(19) Europäisches Patentamt
European Patent Office
Office européen des brevets

(11) **EP 3 073 298 A1**

(12) **EUROPEAN PATENT APPLICATION**
published in accordance with Art. 153(4) EPC

(43) Date of publication:
**28.09.2016 Bulletin 2016/39**

(21) Application number: **14864672.2**

(22) Date of filing: **11.11.2014**

(51) Int Cl.:
*G02B 1/11* (2015.01)     *C08F 2/46* (2006.01)
*C08F 220/20* (2006.01)     *H01L 21/027* (2006.01)

(86) International application number:
**PCT/JP2014/079805**

(87) International publication number:
**WO 2015/076148 (28.05.2015 Gazette 2015/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.11.2013   JP 2013242175**

(71) Applicant: **Soken Chemical & Engineering Co., Ltd.**
**Toshima-ku**
**Tokyo 171-8531 (JP)**

(72) Inventor: **MIYAZAWA, Yukihiro**
**Sayama-shi**
**Saitama 350-1320 (JP)**

(74) Representative: **Gulde & Partner**
**Patent- und Rechtsanwaltskanzlei mbB**
**Wallstraße 58/59**
**10179 Berlin (DE)**

(54) **LIGHT-CURABLE IMPRINTING-RESIN COMPOSITION AND ANTI-REFLECTIVE FILM**

(57) An imprinting photo curable resin composition is provided that is excellent in both transferability in imprinting and solvent resistance of the pattern transferred to a structure. According to the present invention, an imprinting photo curable resin composition is provided that at least includes a photopolymerizable (meth)acrylic monomer (A) and a photo initiator (B), wherein the (meth)acrylic monomer (A) is composed at ratios of: (a-1) from 60 to 97 mass% of a trifunctional (meth)acrylate compound; (a-2) from 3 to 40 mass% of a tetrafunctional or higher functional (meth)acrylate compound; and (a-3) from 0 to 37 mass% of a bifunctional or lower functional (meth)acrylate compound (where a sum from (a-1) to (a-3) is 100 mass%).

**Description**

**Technical Field**

The present invention relates to an imprinting photo curable resin composition and an antireflection film.

**Background Art**

An imprint technique is a micromachining technique in which a mold having a fine pattern is pressed against a resin layer of a liquid resin and the like on a substrate to thus transfer the pattern of the mold to the resin layer. Such fine pattern includes those in the nanoscale at the 10 nm level and those in approximately 100 $\mu$m and is used in various fields, such as semiconductor materials, optical materials, storage media, micromachines, biotechnology, and environmental technology.

Examples of the imprint method may include thermal imprint where a mold with a predetermined shape formed in the surface is pressure welded on a thermoplastic resin melted at the glass transition temperature or higher to thermally imprint the surface shape of the mold to the thermoplastic resin, and after cooling, the mold is removed and light imprint where a mold same as above is pressed against a photo curable resin to cure the photo curable resin by ultraviolet radiation, followed by removal of the mold.

In such light imprint, there is a problem that the resin curing shrinks when it is cured, resulting in manufacturing a structure not having the shape of the pattern of the original mold accurately reflected. In addition, in light imprint to transfer a microstructure in the nano or micron scale, even an error in dimensions in the nano or micron scale becomes a problem.

In PTL 1, using a curable composition of two or more layers, by varying the content of a curable functional group equivalent in the curable composition from the side adjacent to the substrate to the side adjacent to the mold, release properties from the mold is increased while close adhesion to the substrate is maintained to increase the accuracy of the pattern formed in the structure.

**Citation List**

**Patent Literature**

PTL 1: JP 2011-168003A

**Summary of Invention**

**Technical Problem**

After a mold pattern is transferred to the structure, process to make contact with an organic solvent, such as isopropyl alcohol, (e.g., degreasing, overcoating of a solvent-containing resin, etc.) is prepared. In such process, accuracy of the pattern shape transferred to the structure sometimes decreases. Accordingly, in order to increase the accuracy of the finally obtained structure shape, both transferability of the pattern in imprinting and solvent resistance of the pattern transferred to the structure have to be excellent.

The present invention has been made in view of such circumstances and is to provide an imprinting photo curable resin composition that is excellent in both transferability of the pattern in imprinting and solvent resistance of the pattern transferred to the structure.

**Solution to Problem**

According to the present invention, an imprinting photo curable resin composition is provided that at least includes a photopolymerizable (meth)acrylic monomer (A) and a photo initiator (B), wherein the (meth)acrylic monomer (A) is composed at ratios of:

(a-1) from 60 to 97 mass% of a trifunctional (meth)acrylate compound;
(a-2) from 3 to 40 mass% of a tetrafunctional or higher functional (meth)acrylate compound; and
(a-3) from 0 to 37 mass% of a bifunctional or lower functional (meth)acrylate compound

(where a sum from (a-1) to (a-3) is 100 mass%).
Based on intensive examinations to achieve both transferability and solvent resistance, the present inventor found that excellent results in both transferability and solvent resistance were obtained by blending at specific ratios, for a curable resin composition, a trifunctional (meth)acrylate compound and a tetrafunctional or higher functional (meth)acrylate compound and thus has come to complete the present invention.

Various embodiments of the present invention are exemplified below. Embodiments shown below may be combined with each other.

It is preferred that the photo initiator is made by combining an alkylphenon-based photo initiator (B1) and an acylphosphine oxide-based photo initiator (B2).

It is preferred that a blend weight ratio (B1:B2) of the alkylphenon-based photo initiator (B1) to the acylphosphine oxide-based photo initiator (B2) is within a range from 1:99 to 90:10.

It is preferred that transferability of a fine pattern with an amount of the integral light of 200 mJ/cm$^2$ is 97% or more and solvent resistance of the fine pattern is less than 2%.

According to another aspect of the present invention, an antireflection film is provided that includes a resin layer containing the above imprinting photo curable resin composition, the resin layer formed with a fine pattern.

**Description of Embodiments**

The present invention is specifically described below.

The present invention is an imprinting photo curable resin composition that at least includes a photopolymerizable (meth)acrylic monomer (A) and a photo initiator (B), wherein the (meth)acrylic monomer (A) contains multiple types of (meth)acrylate compounds at specific blend ratios.

The (meth)acryl herein means methacryl and/or acryl and the (meth)acrylate means methacrylate and/or acrylate.

<Imprinting Photo Curable Resin Composition>

1. (Meth)acrylic Monomer (A)

The (meth)acrylic monomer contained in the imprinting photo curable resin composition of the present invention contains multiple types of (meth)acrylate compounds at the following blend ratios:

   (a-1) from 60 to 97 mass% of a trifunctional (meth)acrylate compound;
   (a-2) from 3 to 40 mass% of a tetrafunctional or higher functional (meth)acrylate compound; and
   (a-3) from 0 to 37 mass% of a bifunctional or lower functional (meth)acrylate compound

(where a sum from (a-1) to (a-3) is 100 mass%).

Preferably, (a-1) is composed in an amount from 65 to 95 mass%, and specifically 60, 65, 70, 75, 80, 85, 90, 95, and 97 mass%, for example, and may be within a range between any two of the numerical values exemplified here. Preferably, (a-2) is composed in an amount from 3 to 30 mass%, and specifically 3, 5, 10, 15, 20, 25, 30, 35, and 40 mass%, for example, and may be within a range between any two of the numerical values exemplified here.

The trifunctional (meth)acrylate compound is a (meth)acrylate compound having three (meth)acrylate groups, and examples of it may include trimethylolpropane tri(meth)acrylate, ethylene oxide modified trimethylolpropane tri(meth)acrylate, pentaerythritol tri(meth)acrylate, and the like.

The tetrafunctional or higher functional (meth)acrylate compound is a (meth)acrylate compound having four or more (meth)acrylate groups, and examples of it may include pentaerythritol tetra(meth)acrylate, dipentaerythritol penta(meth)acrylate monopropionate, dipentaerythritol hexa(meth)acrylate, tetramethylolethane tetra(meth)acrylate, oligoester tetra(meth)acrylate, and the like.

The bifunctional or lower functional (meth)acrylate compound is a (meth)acrylate compound having two or more (meth)acrylate groups, and examples of it may include a bifunctional (meth)acrylate compound and a monofunctional (meth)acrylate compound.

Examples of the bifunctional (meth)acrylate compound may include tripropylene glycol di(meth)acrylate, ethylene oxide modified bisphenol A di(meth)acrylate, 1,4-butanediol di(meth)acrylate, 1,6-hexanediol di(meth)acrylate, 1,9-nonanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane di(meth)acrylate, and the like.

Examples of the monofunctional(meth)acrylate compound may include:

   (meth)acrylate having a linear alkyl group, such as methyl (meth)acrylate, ethyl (meth)acrylate, n-propyl (meth)acrylate, n-butyl (meth)acrylate, n-pentyl (meth)acrylate, n-hexyl (meth)acrylate, n-octyl (meth)acrylate, n-nonyl (meth)acrylate, decyl (meth)acrylate, dodecyl (meth)acrylate, and stearyl (meth)acrylate;

(meth)acrylic alkyl ester having a branched alkyl group, such as iso-propyl (meth)acrylate, iso-butyl (meth)acrylate, tert-butyl (meth)acrylate, 2-ethylhexyl (meth)acrylate, and isooctyl (meth)acrylate;

(meth)acrylic alkyl ester having a cyclic alkyl group, such as isobornyl (meth)acrylate and cyclohexyl (meth)acrylate; and

(meth)acrylic ester having an aromatic ring group, such as benzyl (meth)acrylate and phenoxyethyl (meth)acrylate.

The above (a-1) through (a-3) may be a functional group containing monomer. Examples of the functional group containing monomer may include a hydroxyl group containing monomer, an acid group containing monomer, an amino group containing monomer, an amide group containing monomer, and a cyano group containing monomer.

Here, examples of the hydroxyl group containing monomer may include hydroxyl group containing compounds, such as a hydroxyl group containing (meth)acrylic monomer like (meth)acrylic acid-2-hydroxyethyl, (meth)acrylic acid-2-hydroxypropyl, (meth)acrylic acid-4-hydroxybutyl, monoester of (meth)acrylic acid with polypropylene glycol or polyethylene glycol, and an addition of lactones with (meth)acrylic acid-2-hydroxyethyl.

In addition, examples of the acid group containing monomer may include carboxyl group containing (meth)acrylic monomers, such as (meth)acrylic acid, acid anhydride group containing (meth)acrylic monomers, phosphoric acid group containing (meth)acrylic monomers, and sulfuric acid group containing (meth)acrylic monomers.

Further, examples of the amino group containing monomer or the amide group containing monomer may include amino group containing (meth)acrylic monomers, such as N,N-dimethylaminoethyl (meth)acrylate, and amide group containing (meth)acrylic monomers, such as (meth)acrylamide, N-methyl (meth)acrylamide, N-ethyl (meth)acrylamide, N-propyl (meth)acrylamide, and N-hexyl (meth)acrylamide.

Moreover, examples of the cyano group containing monomer may include cyano (meth)acrylate and the like.

Further, examples of the (meth)acrylic monomer may include, other than the above (meth)acrylic monomers, another (meth)acrylic monomer, as described below, copolymerizable with the above (meth)acrylic monomers.

Examples of such another copolymerizable (meth)acrylic monomer may include epoxy group containing (meth)acrylate, such as glycidyl (meth)acrylate and 4-hydroxybutyl (meth)acrylate glycidyl ether, alkoxy (meth)acrylate, and allyl (meth)acrylate.

Among the above (meth)acrylic monomers (A), monomers of ethylene oxide modified trimethylolpropane triacrylate, ethylene oxide modified bisphenol A diacrylate, and tripropylene glycol diacrylate are preferred.

The imprinting photo curable resin composition of the present invention may contain, other than the (meth)acrylic monomer (A), another photopolymerizable monomer without impairing the properties of the present invention. Examples of such another photopolymerizable monomer may include a styrene-based monomer and a vinyl-based monomer.

Here, examples of the styrene-based monomer may include: alkylstyrene, such as styrene, methylstyrene, dimethylstyrene, trimethylstyrene, ethylstyrene, diethylstyrene, triethylstyrene, propylstyrene, butylstyrene, hexylstyrene, heptylstyrene, and octylstyrene; styrene halide, such as fluorostyrene, chlorostyrene, bromostyrene, dibromostyrene, and iodostyrene; nitrostyrene; acetylstyrene; methoxystyrene; and the like.

Examples of the vinyl-based monomer may include: vinylpyridine, vinylpyrrolidone, vinylcarbazole, divinylbenzene, vinyl acetate, and acrylonitrile; conjugated diene monomers, such as butadiene, isoprene, and chloroprene; vinyl halide, such as vinyl chloride and vinyl bromide; vinylidene halide, such as vinylidene chloride; and the like.

In the imprinting photo curable resin composition of the present invention, the another photopolymerizable monomer other than the (meth)acrylic monomer (A) is preferably used in an amount, based on 100 parts by mass of the (meth)acrylic monomer (A) in the imprinting photo curable resin composition, from 0 to 30 parts by mass and more preferably from 0 to 10 parts by mass. When the photopolymerizable monomer other than the (meth)acrylic monomer (A) is used in an amount within the above range, it is possible to form a tough and accurate structure.

The (meth)acrylic monomers and the another photopolymerizable monomers exemplified above may be used singly or in combination.

2. Photo Initiator (B)

The photo initiator is a component added to promote polymerization of the monomer and is contained, for example, 0.1 parts by mass or more based on 100 parts by mass of the monomer. Although the upper limit of the content of the photo initiator is not particularly defined, it is, for example, 20 parts by mass based on 100 parts by mass of the monomer. The content of the photo initiator is specifically, for example, 0.1, 0.5, 1, 2, 3, 4, 5, 6, 7, 8, 9, 10, 15, or 20 parts by mass based on 100 parts by mass of the monomer and may be within a range between any two of the numerical values exemplified here. Although the type of photo initiator is not particularly limited, an alkylphenon-based photo initiator (B1) and an acylphosphine oxide-based photo initiator (B2) are preferably used in combination.

The alkylphenon-based photo initiator (B1) and the acylphosphine oxide-based photo initiator (B2) are used in combination as the photo initiator, thereby adequately reducing the polymerization rate to cause the unpolymerized resin composition to enter between the resin shrunk by the polymerization and the master mold for polymerization. It is thus possible to reduce curing shrinkage of the structure obtained by photo curing of the composition of the present invention. In addition, since the resin polymerized later sufficiently forms a crosslinking structure on the surface, it has hardness higher than that of the resin polymerized earlier and thus the surface hardness is considered to be increased.

In the present invention, regarding the amounts of both photo initiators used in the imprinting photo curable resin composition, the alkylphenon-based photo initiator (B1) is used preferably from 0.01 to 20 parts by mass, more preferably from 0.1 to 15 parts by mass, and even more preferably from 0.5 to 10 parts by mass based on 100 parts by mass of the (meth)acrylic monomer (A) in the imprinting photo curable resin composition, and the acylphosphine oxide-based photo initiator (B2) is used preferably from 0.01 to 20 parts by mass, more preferably from 0.1 to 15 parts by mass, and even more preferably from 0.5 to 10 parts by mass.

Use of the alkylphenon-based photo initiator (B1) and the acylphosphine oxide-based photo initiator (B2) within the above ranges enables control of the amount of generated radicals.

A weight ratio (B1:B2) of the alkylphenon-based photo initiator (B1) to the acylphosphine oxide-based photo initiator (B2) is from 1:99 to 90:10, preferably from 5:95 to 80:20, more preferably from 10:90 to 70:30, and most preferably from 10:90 to 40:60.

Use of the alkylphenon-based photo initiator (B1) and the acylphosphine oxide-based photo initiator (B2) in the above weight ratio enables formation of a relatively rigid polymer by adequately reducing the polymerization rate and also enables suppression of yellowing of the obtained polymer.

The alkylphenon-based photo initiator is preferably a compound not containing nitrogen, more preferably at least one selected from the group consisting of 2,2-dimethoxy-1,2-diphenylethane-1-one, 1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-one, and 2-hydroxy-1-{[4-(2-hydroxy-2-methyl-propionyl)-benzil]phenyl}-2-methyl-propane-1-one, and most preferably 1-hydroxy-cyclohexyl-phenyl-ketone.

Commercially available examples of the alkylphenon-based photo initiator may include IRGACURE 651, IRGACURE 184, IRGACURE 2959, IRGACURE 127, IRGACURE 907, IRGACURE 369 (all produced by BASF SE) and IRGACURE 1173 (produced by Ciba Japan K.K.).

The acylphosphine oxide-based photo initiator is preferably at least one selected from the group consisting of 2,4,6-trimethylbenzoyl-diphenyl-phosphine oxide and bis(2,4,6-trimethylbenzoyl)-phenylphosphine oxide and most preferably bis(2,4,6-trimethylbenzoyl)-phenylphosphine oxide.

Commercially available examples of the acylphosphine oxide-based photo initiator may include LUCIRIN TPO and IRGACURE 819 (both produced by BASF SE).

3. Others

The imprinting photo curable resin composition of the present invention may contain components, such as a solvent, a chain transfer agent, an antioxidant, a photosensitizer, a filler, and a leveling agent, without affecting the properties of the imprinting photo curable resin composition.

It is possible to manufacture the imprinting photo curable resin composition of the present invention by mixing the above components in a known method.

<Method of Using Imprinting Photo Curable Resin Composition>

The imprinting photo curable resin composition of the present invention is used for light imprint for manufacturing a structure with a fine pattern formed on a surface of a master mold and the like.

The light imprint includes:

(I-1) a procedure of applying the imprinting photo curable resin composition of the present invention on a substrate;
(II-1) a procedure of causing a master mold with a fine pattern formed on a surface to abut on the imprinting photo curable resin composition on the substrate;
(III) a procedure of curing the imprinting photo curable resin composition by radiating light to the imprinting photo curable resin composition between the substrate and the master mold; and
(IV) a procedure of releasing the master mold from the cured imprinting photo curable resin composition.

The procedures (I) and (II) may be:

(I-2) a procedure of dropping the imprinting photo curable resin composition of the present invention on a master mold with a fine pattern formed on a surface; and
(II-2) a procedure of covering a surface of the imprinting photo curable resin composition with a substrate.

As a result, a structure is manufactured that has a surface with the fine pattern on the surface of the master mold transferred thereto.

Examples of the substrate in the procedures (I-1) and (II-2) may include a resin, glass, silicon, sapphire, gallium nitride, carbon, silicon carbide, and the like.

Examples of the resin used for the above substrate may preferably include polyethylene terephthalate, polycarbonate, polyester, methyl polymethacrylate, polystyrene, polyolefin, polyimide, polysulfone, polyethersulfone, polyethylene naphthalate, and the like.

Examples of the form of resin used for the above substrate may include the form of the resin above and the form of a film. These forms are selected depending on the type of imprint.

Examples of the method of applying the imprinting photo curable resin composition of the present invention in the procedure (I-1) on the substrate may include spin coating, spray coating, bar coating, dip coating, die coating, slit coating, and the like.

The amount of applying the imprinting photo curable resin composition of the present invention on the substrate in the procedure (I-1) and the amount of dropping it on the master mold in the procedure (I-2) is preferably from $1 \times 10^{-4}$ to $1 \times 10^{-1}$ g/cm2 and more preferably from $1 \times 10^{-3}$ to $1 \times 10^{-2}$ g/cm$^2$.

The fine pattern formed in the surface of the master mold in the procedures (II-1) and (I-2) is normally concave and convex and is a pattern repeated on a regular cycle. That is, the pattern is a fine pattern, which preferably has a cycle from 10 nm to 50 $\mu$m, a depth from 10 nm to 100 $\mu$m, and a transfer surface from 1.0 to $1.0 \times 106$ mm$^2$.

Examples of the specific concave and convex shape may include a moth eye structure, lines, columns, monoliths, circular cones, polygonal pyramids, and microlense arrays.

In the procedure (II-1), the master mold abuts on the imprinting photo curable resin composition of the present invention normally at strength from $1.0 \times 10^{-3}$ to 1.0 MPa and normally holds from 1 to 300 seconds.

Examples of the light in the procedure (III) may include active energy rays, such as ultraviolet rays, visible light rays, infrared rays, and electron beams. The condition for light radiation is normally from 100 to 18,000 mJ/cm$^2$.

In the procedure (IV), an operation to detach the master mold from the cured resin is performed.

By the above light imprint, the imprinting photo curable resin composition of the present invention becomes a structure with the fine pattern of the master mold transferred to the surface.

<Structure Obtained from Imprinting Photo Curable Resin Composition>

1. Physical Properties of Structure

The structure that is obtained by light imprint of the imprinting photo curable resin composition of the present invention and has the fine pattern of the master mold transferred to the surface has the following physical properties.

The transferability of the fine pattern formed in the surface of the structure is preferably 97% or more and even more preferably 99% or more. The solvent resistance of the fine pattern is preferably 2% or less and even more preferably 1% or less. Specific methods of evaluating the transferability and the solvent resistance are described in Examples.

The reasons for such transferability and solvent resistance are because the imprinting photo curable resin composition of the present invention contains the trifunctional (meth)acrylate compound and the tetrafunctional or higher functional (meth)acrylate compound at the specific blend ratios.

2. Applications of Structure

Although the applications of the structure with a fine pattern formed in the resin layer of the imprinting photo curable resin composition of the present invention are not particularly limited, the composition may be used as, for example, an antireflection film. In this case, the fine pattern formed in the surface of the structure is preferably in a moth eye shape.

Examples [0054]

Examples and Comparative Examples of the present invention are described below.

Firstly, a fine pattern (moth eye pattern with a shape height of 339 nm and a cycle of 350 nm) of a master mold made of nickel was subjected to release treatment with a fluorine-based mold release agent (OPTOOL HD-2100 produced by Daikin Industries, Ltd.).

Then, a photo curable resin composition of composition indicated in Table 1 was dropped on the master mold and the resin composition was covered with a PET (polyethylene terephthalate) substrate, followed by rolling a roller on the substrate to uniformly extend the resin liquid ($2.5 \times 10^{-3}$ g/cm$^2$). After that, UV light was radiated in an amount of the integral light of 200 mJ/cm$^2$ by a UV irradiation device (manufactured by Technovision, Inc., model: UVC-408) to cure the resin, followed by releasing the lamination of PET / the cured resin from the master mold to obtain a sample. The sample thus obtained is referred to below as a "structure".

(Evaluation of Transferability)

For this structure, the shape height of the fine pattern was measured using a scanning probe microscope (manufactured by Hitachi High-Tech Science Corp., trade name: L-trace) and the transferability was calculated according to Equation 1 below to evaluate based on the following criteria.

Transferability (%) = {(Shape Height of Fine Pattern of Structure)/(Shape Height of Fine Pattern of Master Mold)}x100 (Equation 1)
☉: 99% or more of transferability
○: Not less than 97% and less than 99% of transferability
X: Less than 97% of transferability

(Evaluation of Solvent Resistance)

Then, the structure thus obtained was immersed in an organic solvent (isopropyl alcohol) for three minutes and the shape height of the fine pattern of the structure was measured in the same manner as the evaluation of the transferability and the solvent resistance was calculated according to Equations 2 and 3 below to evaluate based on the following criteria.

$$\text{Solvent Resistance (\%)} = (1 - \text{Rate of Shape Height Reduction}) \times 100 \qquad \text{(Equation 2)}$$

$$\text{Rate of Shape Height Reduction} = \{(\text{Shape Height of Fine Pattern of Structure after Immersion in Organic Solvent})/(\text{Shape Height of Fine Pattern of Structure before Immersion in Organic Solvent})\} \qquad \text{(Equation 3)}$$

☉: Less than 1% of solvent resistance
○: Not less than 1% and less than 2% of solvent resistance
X: 2% or more of solvent resistance

[Table 1]

| Table 1 | | | Number of (Meth) Acrylate Groups | Examples | | | | Comparative Examples | | | |
|---|---|---|---|---|---|---|---|---|---|---|---|
| | | | | 1 | 2 | 3 | 4 | 1 | 2 | 3 | 4 |
| (Meth) Acrylic Monomer (A) | TMPTA | | 3 | 80.0 | 80.0 | 95.0 | 70.0 | 25.0 | 50.0 | 69.1 | 50.0 |
| | EO Modified TMPTA | | 3 | | | | | | | 30.9 | |
| | DPHA | | 6 | 20.0 | 20.0 | 5.0 | 15.0 | | | | 50.0 |
| | M-211B | | 2 | | | | 15.0 | 75.0 | 50.0 | | |
| Photo Initiator (B) | Alkylphenon-Based | IRGACURE 184 | | 1.0 | 1.0 | 1.0 | 1.0 | 1.0 | 1.0 | | |
| | | IRGACURE907 | | 3.0 | | | | | | | |
| | Acylphosphine Oxide-Based | IRGACURE 819 | | | 5.0 | 5.0 | 5.0 | 3.0 | 3.0 | | |
| | | TPO-L | | | | | | | | 3.0 | 3.0 |
| Evaluation | Transferability | | | ○ | ⊙ | ⊙ | ⊙ | ⊙ | ⊙ | ○ | X |
| | Solvent Resistance | | | ⊙ | ⊙ | ⊙ | ⊙ | X | X | X | ⊙ |

Abbreviations in Table 1 denote as follows. TMPTA: trimethylolpropane triacrylate
EO modified TMPTA: ethylene oxide modified trimethylolpropane triacrylate
DPHA: dipentaerythritol hexaacrylate
M-211B: bisphenol A ethylene oxide modified diacrylate (produced by Toagosei Co., Ltd.)
IRGACURE 184: 1-hydroxy-cyclohexyl phenyl ketone (produced by BASF SE)
IRGACURE 907: 2-methyl-1-(4-methylthiophenyl)-2-morpholinopropane-1-one (produced by BASF SE)
IRGACURE 819: bis(2,4,6-trimethylbenzoyl)phenylphosphine oxide (produced by BASF SE)
TPO-L: 2,4,6-trimethylbenzoyl-ethoxyphenyl-phosphine oxide (produced by BASF SE)

(Discussion)

As shown in Comparative Examples 1 through 3, when a photo curable resin composition not containing a tetrafunctional or higher functional (meth)acrylate compound is used, the transferability was good but the solvent resistance was poor. In addition, as shown in Comparative Example 4, when a photo curable resin composition excessively containing a tetrafunctional (meth)acrylate compound is used, the solvent resistance was good but the transferability was poor.

In contrast, as shown in Examples 1 through 4, when a photo curable resin composition containing a trifunctional (meth)acrylate compound and a tetrafunctional or higher functional (meth)acrylate compound at specific blend ratios is used, good results in both the transferability and the solvent resistance were obtained.

Regarding the photo initiator, as shown in Examples 2 through 4, an alkylphenon-based photo initiator and an acylphosphine oxide-based photo initiator were used in combination, thereby obtaining particularly good results in the transferability.

**Claims**

1. An imprinting photo curable resin composition, at least comprising a photopolymerizable (meth)acrylic monomer (A) and a photo initiator (B), wherein

   the (meth)acrylic monomer (A) is composed at ratios of:

      (a-1) from 60 to 97 mass% of a trifunctional (meth)acrylate compound;
      (a-2) from 3 to 40 mass% of a tetrafunctional or higher functional (meth)acrylate compound; and
      (a-3) from 0 to 37 mass% of a bifunctional or lower functional (meth)acrylate compound

   wherein a sum from (a-1) to (a-3) is 100 mass%.

2. The imprinting photo curable resin composition according to claim 1, wherein the photo initiator is made by combining an alkylphenon-based photo initiator (B1) and an acylphosphine oxide-based photo initiator (B2).

3. The imprinting photo curable resin composition according to claim 2, wherein a blend weight ratio (B1:B2) of the alkylphenon-based photo initiator (B1) to the acylphosphine oxide-based photo initiator (B2) is within a range from 1:99 to 90:10.

4. The imprinting photo curable resin composition according to any one of Claims 1 through 3, wherein transferability of a fine pattern with an amount of the integral light of 200 mJ/cm$^2$ is 97% or more and solvent resistance of the fine pattern is less than 2%.

5. An antireflection film comprising a resin layer containing the imprinting photo curable resin composition according to any one of claims 1 through 4, the resin layer formed with a fine pattern.

## INTERNATIONAL SEARCH REPORT

| International application No. |
|---|
| PCT/JP2014/079805 |

A. CLASSIFICATION OF SUBJECT MATTER
*G02B1/11*(2015.01)i, *C08F2/46*(2006.01)i, *C08F220/20*(2006.01)i, *H01L21/027*
(2006.01)i

According to International Patent Classification (IPC) or to both national classification and IPC

B. FIELDS SEARCHED

Minimum documentation searched (classification system followed by classification symbols)
H01L21/027, G01B1/11

Documentation searched other than minimum documentation to the extent that such documents are included in the fields searched
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2013-168522 A (Sanyo Chemical Industries, | 1-3 |
| Y | Ltd.), | 4-5 |
| | 29 August 2013 (29.08.2013), | |
| | examples 6, 8 | |
| | (Family: none) | |
| | | |
| Y | JP 2013-175733 A (Mitsubishi Rayon Co., Ltd.), | 4-5 |
| | 05 September 2013 (05.09.2013), | |
| | paragraphs [0155] to [0156] | |
| | & US 2013/0302564 A1  & EP 2664636 A1 | |
| | & WO 2012/096322 A1  & TW 201234105 A | |
| | & KR 10-2013-0084699 A  & CN 103282394 A | |
| | | |
| Y | JP 2012-227190 A (Nippon Shokubai Co., Ltd.), | 4-5 |
| | 15 November 2012 (15.11.2012), | |
| | example 1 | |
| | (Family: none) | |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 January 2015 (23.01.15) | 03 February 2015 (03.02.15) |

| Name and mailing address of the ISA/ | Authorized officer |
|---|---|
| Japan Patent Office | |
| 3-4-3,Kasumigaseki,Chiyoda-ku, | |
| Tokyo 100-8915,Japan | Telephone No. |

Form PCT/ISA/210 (second sheet) (July 2009)

**INTERNATIONAL SEARCH REPORT**

| International application No. |
| --- |
| PCT/JP2014/079805 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2011-231308 A  (Fujifilm Corp.), <br> 17 November 2011 (17.11.2011), <br> paragraph [0009] <br> & US 2012/0076950 A1    & EP 2556532 A <br> & WO 2011/126101 A1    & TW 201135363 A <br> & KR 10-2012-0135385 A | 4-5 |
| A | JP 2011-235571 A  (Fujifilm Corp.), <br> 24 November 2011 (24.11.2011), <br> paragraph [0085]; table 2 <br> (Family: none) | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2011168003 A